# EUROPEAN PATENT APPLICATION

(11) **EP 4 664 529 A1**
(43) Date of publication of application: **17.12.2025**
(21) Application number: 23925771.0
(22) Date of filing: 09.03.2023
(51) Int. Cl.: H01L 27/15, H01L 27/12

(54) **LIGHT-EMITTING SUBSTRATE AND MANUFACTURING METHOD THEREFOR, BACKLIGHT SOURCE, AND DISPLAY DEVICE**

(71) Applicant: Boe Technology Group Co., Ltd., Beijing 100015 (CN)
(72) Inventor: ZHOU, Jingshang, Beijing 100176 (CN); LV, Zhijun, Beijing 100176 (CN); LU, Xinhong, Beijing 100176 (CN); WANG, Ke, Beijing 100176 (CN); CAO, Zhanfeng, Beijing 100176 (CN); ZHANG, Jiaxiang, Beijing 100176 (CN); QI, Qi, Beijing 100176 (CN); LIU, Chunjian, Beijing 100176 (CN); TIAN, Jian, Beijing 100176 (CN); LEI, Jie, Beijing 100176 (CN); MA, Yajun, Beijing 100176 (CN); ZHANG, Jianying, Beijing 100176 (CN)
(74) Representative: Studio Torta S.p.A.
(86) International application number: PCT/CN2023/080465
(87) International publication number: WO 2024/183053

(57) **Abstract**

A light-emitting substrate, a method of preparing a light-emitting substrate, a backlight and a display device. The light-emitting substrate includes: a base substrate including a plurality of light-emitting regions; a plurality of light-emitting elements in each of the plurality of light-emitting regions; a connection line in each light-emitting region and configured to connect the light-emitting elements in each light-emitting region; and a first auxiliary plating in each light-emitting region and electrically insulated from the connecting line and the light-emitting elements.

## Description

### TECHNICAL FIELD

The present disclosure relates to the field of display technology, and in particular, to a light-emitting substrate and a method of preparing the light-emitting substrate, a backlight and a display device comprising the light-emitting substrate.

### BACKGROUND

Mini light-emitting diode (referred to as Mini LED) and micro light-emitting diode (referred to as Micro LED) are a new type of LED display technology derived from small-pitch LEDs. Generally, the size of Mini LED is about 100-300 µm, and the size of Micro LED is below 100 µm. Since Mini LED and Micro LED display devices have advantages such as self-light-emitting, all-solid-state, long lifetime, high brightness, low power consumption, small volume, ultra-high resolution, applicable to extreme environments such as high temperature or radiation, and not easily affected by the environment for materials, they can be widely used in the display field such as the display screen, the backlight, and the lighting, and are considered as the next generation of new display technology.

### SUMMARY

According to an aspect of the present disclosure, a light-emitting substrate is provided. The light-emitting substrate comprises: a base substrate comprising a plurality of light-emitting regions; a plurality of light-emitting elements in each of the plurality of light-emitting regions; a connection line in each light-emitting region and configured to connect the light-emitting elements in each light-emitting region; and a first auxiliary plating in each light-emitting region and electrically insulated from the connection line and the light-emitting elements.

In some embodiments, each light-emitting region comprises a region occupied by the connection line and a blank region not occupied by the connection line, the first auxiliary plating is in the blank region, the first auxiliary plating comprises a main body extending along a first direction, the main body divides the blank region into a first portion and a second portion, and an area of the first portion is substantially equal to an area of the second portion.

In some embodiments, the first auxiliary plating further comprises a sub-part extending along a second direction and connected to the main body, the first direction intersects with the second direction.

In some embodiments, the main body of the first auxiliary plating comprises a first end and a second end opposite to each other in the first direction, the first end is closer to the connection line that is in a same light-emitting region as the first auxiliary plating compared to the second end, and the sub-part is connected to the second end of the main body.

In some embodiments, the first auxiliary plating has an open-loop structure.

In some embodiments, the first auxiliary plating further comprises a sub-part extending along a second direction and connected to the main body, the first direction intersects with the second direction, the main body is a rectangular ring comprising an opening to form the open-loop structure.

In some embodiments, the main body of the first auxiliary plating comprises a first edge and a second edge opposite to each other in the first direction and a side edge connecting the first edge and the second edge, the opening is at the side edge, and the first edge is closer to the connection line that is in a same light-emitting region as the first auxiliary plating compared to the second edge, and the sub-part comprises a first sub-part and a second sub-part, the first sub-part is connected to the second edge and the side edge of the main body, the second sub-part is connected to the side edge of the main body and is closer to the second edge compared to the first edge, and the opening is between the first sub-part and the second sub-part.

In some embodiments, the first auxiliary plating comprises three third sub-parts extending along the first direction and four fourth sub-parts extending along a second direction, the first direction intersects with the second direction, two of the four fourth sub-parts comprise an opening, the third sub-parts are connected to the fourth sub-parts to make an outline of the first auxiliary plating be the open-loop structure with an L shape, and any two adjacent third sub-parts among the three third sub-parts have substantially equal spacing, and any two adjacent fourth sub-parts among the four fourth sub-parts have substantially equal spacing.

In some embodiments, the light-emitting substrate further comprises: a bonding region; a plurality of bonding electrodes in the bonding region; and a second auxiliary plating on both sides of the plurality of bonding electrodes in a second direction, the second auxiliary plating being electrically insulated from the plurality of bonding electrodes.

In some embodiments, the second auxiliary plating comprises a plurality of auxiliary electrodes, a width of each of the plurality of auxiliary electrodes along the second direction is equal to a width of each of the plurality of bonding electrodes along the second direction, and a spacing between any two adjacent auxiliary electrodes among the plurality of auxiliary electrodes is equal to a spacing between any two adjacent bonding electrodes among the plurality of bonding electrodes.

In some embodiments, the light-emitting substrate further comprises a third auxiliary plating on a side of the plurality of bonding electrodes away from the light-emitting regions and electrically insulated from the plurality of bonding electrodes, the third auxiliary plating is in a strip shape, and a length of the third auxiliary plating along the second direction is greater than a length spanned by the plurality of bonding electrodes along the second direction.

In some embodiments, the third auxiliary plating is connected to the second auxiliary plating.

In some embodiments, the third auxiliary plating is not connected to the second auxiliary plating, and a distance between the third auxiliary plating and the second auxiliary plating is equal to a spacing between any two adjacent bonding electrodes among the plurality of bonding electrodes.

In some embodiments, the light-emitting substrate further comprises: an alignment mark; and an annular auxiliary plating surrounding the alignment mark and electrically insulated from the alignment mark.

In some embodiments, one annular auxiliary plating surrounds one alignment mark.

In some embodiments, one annular auxiliary plating surrounds a plurality of alignment marks.

In some embodiments, the light-emitting substrate further comprises a plurality of driving voltage signal lines extending along a first direction. The plurality of light-emitting regions are arranged in multiple rows and multiple columns, each column of light-emitting regions comprises a driving voltage signal line, and a plurality of connection lines in a same column are connected to a same driving voltage signal line, the connection line in each light-emitting region and the driving voltage signal line connected to the connection line respectively have a first spacing from the first auxiliary plating in the light-emitting region, the first auxiliary plating is in a same layer as the connection line and the driving voltage signal line, and the second auxiliary plating is in a same layer as the bonding electrodes, the connection line and the driving voltage signal line.

In some embodiments, each light-emitting region comprises a region occupied by the connection line and a blank region not occupied by the connection line, the first auxiliary plating is in the blank region and has an open-loop structure, and a width of the first auxiliary plating is greater than or equal to a width of the driving voltage signal line.

In some embodiments, the light-emitting substrate further comprises: a plurality of driving circuits, wherein each light-emitting region comprises a driving circuit connected to the light-emitting elements in the light-emitting region, and the driving circuits in each column of light-emitting regions are cascaded in sequence; and a plurality of common voltage signal lines extending along the first direction, wherein each column of light-emitting regions comprises a common voltage signal line connected to a ground terminal of each driving circuit in a column of light-emitting region.

In some embodiments, the light-emitting substrate further comprises: a plurality of power signal lines extending along the first direction, wherein each column of light-emitting regions comprises a power signal line connected to a power terminal of each driving circuit in the column of light-emitting regions; a plurality of address selection signal lines extending along the first direction, wherein each column of light-emitting regions comprises an address selection signal line connected to an address terminal of a first cascaded driving circuit in the column of light-emitting regions; and a plurality of feedback signal lines extending along the first direction, wherein each column of light-emitting regions comprises a feedback signal line connected to an output terminal of a last cascaded driving circuit in the column of light-emitting regions.

In some embodiments, a spacing between the driving voltage signal line in each column of light-emitting regions and the feedback signal line in another column of light-emitting regions adjacent to the column of light-emitting regions is equal to the first spacing.

In some embodiments, the first spacing is approximately 200 µm.

In some embodiments, the plurality of light-emitting elements are arranged in multiple rows and multiple columns, the driving voltage signal line, the common voltage signal line and the feedback signal line extend beyond the first row of light-emitting elements or at least flush with the first row of light-emitting elements in the first direction.

According to another aspect of the present disclosure, a backlight is provided, which comprises the light-emitting substrate described in any of the previous embodiments.

According to yet another aspect of the present disclosure, a display device is provided, which comprises the light-emitting substrate described in any of the previous embodiments.

According to still another aspect of the present disclosure, a method of preparing a light-emitting substrate is provided, which comprises: providing a base substrate that comprises a plurality of light-emitting regions; forming a connection line and a first auxiliary plating in each of the light-emitting regions of the base substrate; and mounting a light-emitting element on a side of the connection line and the first auxiliary plating in each light-emitting region away from the base substrate. The connection line is configured to connect the light-emitting elements in each light-emitting region, and the first auxiliary plating is electrically insulated from the connection line and the light-emitting elements.

In some embodiments, the light-emitting substrate further comprises a bonding region, the forming the connection line and the first auxiliary plating in each of the light-emitting regions of the base substrate, further comprises: applying a conductive layer on the base substrate and patterning the conductive layer to simultaneously form signal lines, the connection line and the first auxiliary plating in the light-emitting region, a plurality of bonding electrodes in the bonding region, a second auxiliary plating and a third auxiliary plating. The signal lines extend along a first direction, the signal lines comprise a driving voltage signal line, a common voltage signal line, a power signal line, an address selection signal line, and a feedback signal line, the plurality of light-emitting regions are arranged in multiple rows and multiple columns, and each column of light-emitting regions comprises the driving voltage signal line, the common voltage signal line, the power signal line, the address selection signal line, and the feedback signal line, the second auxiliary plating is on both sides of the plurality of bonding electrodes in a second direction and is electrically insulated from the plurality of bonding electrodes, the second direction intersects with the first direction, and the third auxiliary plating is on a side of the plurality of bonding electrodes away from the light-emitting regions and is electrically insulated from the plurality of bonding electrodes, the third auxiliary plating is in a strip shape, and a length of the third auxiliary plating along the second direction is greater than a length spanned by the plurality of bonding electrodes along the second direction.

In some embodiments, the applying the conductive layer on the base substrate and patterning the conductive layer, comprises: forming a first conductive layer on the base substrate; forming a patterned photoresist on a side of the first conductive layer away from the base substrate; forming a second conductive layer on a surface of the first conductive layer that is not shielded by the photoresist through an electroplating addition method, a thickness of the second conductive layer being greater than a thickness of the first conductive layer; stripping the photoresist; and etching the first conductive layer that is exposed.

In some embodiments, a ratio of an area of the second conductive layer to an area of the base substrate is approximately 30%~40%.

In some embodiments, the base substrate comprises four process edges, the method further comprises: forming a fourth auxiliary plating with a strip shape on the four process edges of the base substrate, orthographic projections of the four process edges on the base substrate respectively fall within orthographic projections of four fourth auxiliary platings on the base substrate; and cutting off the four process edges.

### BRIEF DESCRIPTION OF THE DRAWINGS

In order to describe the technical solutions in the embodiments of the present disclosure more clearly, the drawings needed to be used in the embodiments will be briefly introduced below. Obviously, the drawings in the following description are only some embodiments of the present disclosure. Those of ordinary skill in the art can also obtain other drawings based on these drawings without undue experimentation.
Fig. 1 illustrates a schematic plan view of a partial structure of a light-emitting substrate according to an embodiment of the present disclosure;
Fig. 2 illustrates a schematic diagram of the driving circuit and signal lines of the light-emitting substrate of Fig. 1;
Fig. 3 illustrates a schematic plan view of a partial structure of a light-emitting substrate according to an embodiment of the present disclosure;
Fig. 4 illustrates a schematic plan view of a partial structure of a light-emitting substrate according to an embodiment of the present disclosure;
Fig. 5 illustrates a schematic plan view of a partial structure of a light-emitting substrate according to an embodiment of the present disclosure;
Fig. 6 illustrates the wiring of a bonding region of a light-emitting substrate according to an embodiment of the present disclosure;
Fig. 7 illustrates an enlarged view of region I of Fig. 6;
Fig. 8 illustrates an enlarged view of region I of Fig. 6;
Fig. 9A illustrates a schematic plan view of a partial structure of a light-emitting substrate of the related art;
Fig. 9B illustrates a schematic plan view of a partial structure of a light-emitting substrate according to an embodiment of the present disclosure;
Fig. 10 illustrates an arrangement of an alignment mark and an annular auxiliary plating surrounding the alignment mark on a light-emitting substrate according to an embodiment of the present disclosure;
Fig. 11 illustrates another arrangement of an alignment mark and an annular auxiliary plating surrounding the alignment mark on a light-emitting substrate according to an embodiment of the present disclosure;
Fig. 12 illustrates yet another arrangement of an alignment mark and an annular auxiliary plating surrounding the alignment mark on a light-emitting substrate according to an embodiment of the present disclosure;
Fig. 13 illustrates a schematic plan view of a partial structure of a light-emitting substrate according to an embodiment of the present disclosure;
Fig. 14 illustrates a block diagram of a backlight according to an embodiment of the present disclosure;
Fig. 15 illustrates a block diagram of a display device according to an embodiment of the present disclosure;
Fig. 16 illustrates a flow chart of a method of preparing a light-emitting substrate according to an embodiment of the present disclosure;
Fig. 17 illustrates a schematic diagram of a method of preparing a light-emitting substrate according to an embodiment of the present disclosure; and
Fig. 18 illustrates a schematic diagram of another method of preparing a light-emitting substrate according to an embodiment of the present disclosure.

### DETAILED DESCRIPTION OF THE DISCLOSURE

The technical solutions in the embodiments of the present disclosure will be clearly described below with reference to the accompanying drawings. Obviously, the described embodiments are only some, but not all, of the embodiments of the present disclosure. Based on the embodiments of the present disclosure, all other embodiments obtained by those of ordinary skill in the art without undue experimentation fall within the scope of protection of this disclosure.

Since Mini LED and Micro LED have many advantages as mentioned above, more and more manufacturers are replacing the traditional LED in the backlight with Mini LED or Micro LED to form a backlight based on Mini LED or Micro LED. As technology becomes more mature, competition to reduce costs becomes more intense. The production process of signal lines on the backplane of a backlight based on Mini LED or Micro LED has been streamlined from a double-layer conductive layer process (for example, seven masks are used) to the current single-layer conductive layer process (for example, two masks are used), thereby significantly reducing production costs.

The display panel with large size and high resolution requires increasingly narrower width of wiring, but the narrower the width of the wiring, the greater the resistance of the wiring. The double-layer conductive layer is reduced to a single-layer conductive layer, in order to meet the voltage drop requirement and achieve the same electrical performance as the double-layer conductive layer, the thickness of the wiring of the single-layer conductive layer is increased. The material of the wiring is usually copper. Generally, when the copper thickness is less than 2 µm, a sputtering method can be used to prepare the wiring; when the copper thickness is greater than 2 µm, an electroplating method is usually used to prepare the wiring. As the trend of products becomes more and more high-end, the requirement for copper thickness becomes higher and higher. For example, the copper thickness may be 20 µm, 30 µm, or even 50 µm. Copper with such large thickness needs to be prepared by the electroplating method. The electroplating method usually comprises a subtractive method and an addition method. The subtractive method refers to first laying a conductive layer on the entire surface of a substrate, and then selectively removing a portion of the conductive layer to obtain a patterned conductive layer. The addition method refers to selectively depositing a conductive layer on the surface of a substrate with the blocking of photoresist, thereby forming a patterned conductive layer. When the thickness of the conductive layer exceeds 8 µm, the use of the subtractive method will result in long etching time and large etching deviation, resulting in reduced mass productivity of the products. The addition method is not affected by the thickness of the conductive layer, and the etching deviation is almost zero.

However, the addition method requires the photoresist as a barrier, which is a patterned electroplating method. The parameters of the barrier (such as width, spacing, density distribution, etc.) have a certain impact on the electroplating effect, especially when there are "island" lines on the substrate, leading to a poor thickness uniformity of the conductive layer. When a light-emitting device is bonded to a light-emitting substrate comprising a conductive layer with uneven thickness, the height difference between the cathode pad and the anode pad of the light-emitting device will exceed the range that the solder paste can cover, resulting in failure of bonding, and a poor uniformity of light-emitting of the light-emitting substrate and even unable to achieve normal light-emitting function.

In view of this, embodiments of the present disclosure provide light-emitting substrates that can at least alleviate or overcome some or all of the above-mentioned defects and other possible defects.

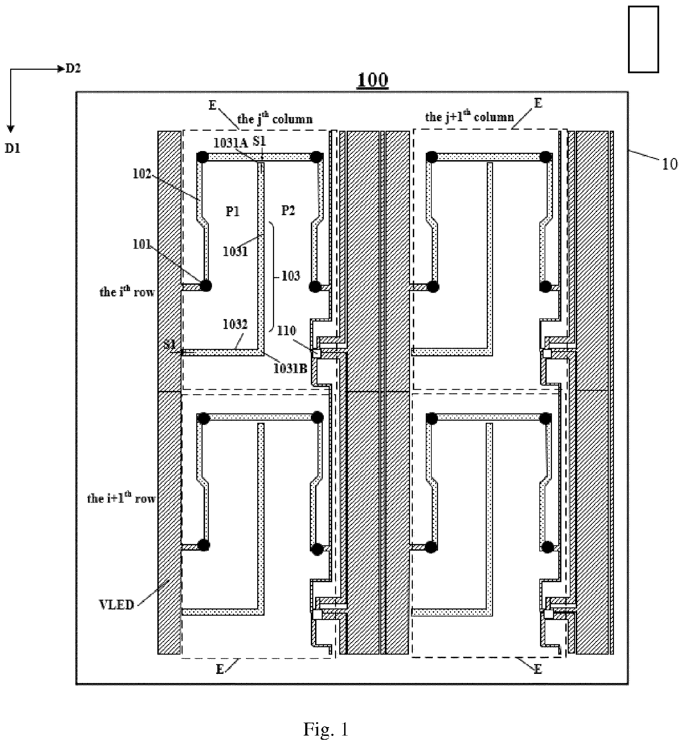

Fig. 1 illustrates a schematic plan view of a partial structure of a light-emitting substrate 100. The light-emitting substrate 100 comprises: a base substrate 10 comprising a plurality of light-emitting regions E; a plurality of light-emitting elements 101 located in each of the plurality of light-emitting regions E; a connection line 102 located in each light-emitting region E and configured to connect the light-emitting elements 101 in each light-emitting region E; and a first auxiliary plating 103 located in each light-emitting region E and electrically insulated from the connection line 102 and the light-emitting elements 101.

It should be noted that Fig. 1 illustrates a partial structure of the light-emitting substrate 100, therefore, only four light-emitting regions E of the light-emitting substrate 100 are illustrated, the four light-emitting regions E are arranged in two rows and two columns, for example, the light-emitting region E located in the i^{th} row and the j^{th} column, the light-emitting region E located in the i^{th} row and the (j+1)^{th} column, the light-emitting region E located in the (i+1)^{th} row and the j^{th} column, and the light-emitting region E located in the (i+1)^{th} row and the (j+1)^{th} column. Each light-emitting region E is marked by a dotted rectangular frame. However, as described above, the light-emitting substrate 100 comprises a plurality of light-emitting regions E arranged in multiple rows and multiple columns. The number of light-emitting elements 101 comprised in each light-emitting region E can be flexibly designed according to specific needs. When each light-emitting region E comprises a plurality of light-emitting elements 101, these light-emitting elements 101 may be connected to each other in series, in parallel, or in a combination of series and parallel through the connection line 102. The light-emitting element 101 may be a Mini LED or a Micro LED. Generally, the size of Mini LED is about 100-300 µm, and the size of Micro LED is below 100 µm.

As illustrated in Fig. 1, if the light-emitting substrate 100 is not provided with the first auxiliary plating 103, there will be almost no other signal lines near the connection line 102 in the light-emitting region E, and a large blank region will appear near the connection line 102, causing the connection line 102 to become an island line. In addition, the width of the signal line VLED is significantly larger than the width of the connection line 102. Such uneven width and uneven distribution of lines bring great challenges to the electroplating addition method. Therefore, the thickness of the connection line 102 formed by the electroplating addition method will be significantly larger than the thickness of other signal lines on the light-emitting substrate 100, which is not conducive to the realization of thickness uniformity. In the embodiment of the present disclosure, by setting the first auxiliary plating 103 in the light-emitting region E, the distribution of lines in the light-emitting region E is more uniform, the island effect of the connection line 102 is improved, thereby reducing or even avoiding the impact of the island effect on the electroplating uniformity, making the thickness of the connection line 102 basically consistent with the thickness of other signal lines on the light-emitting substrate 100, improving the thickness uniformity of lines on the light-emitting substrate 100. When the light-emitting element 101 is bonded to the light-emitting substrate 100, the cathode pad and the anode pad of the light-emitting element 101 have substantially the same height, thereby ensuring that each light-emitting element 101 is firmly bonded to the pad, so that the light-emitting substrate 100 has a uniform light-emitting effect.

Each light-emitting region E comprises a region occupied by the connection line 102 and a blank region not occupied by the connection line 102, the first auxiliary plating 103 is located in the blank region. As illustrated in Fig. 1, the first auxiliary plating 103 comprises a main body 1031 extending along a first direction D1, and the first direction D1 is, for example, the vertical direction in the figure. The main body 1031 divides the blank region into a first portion P1 and a second portion P2, and the area of the first portion P1 is substantially equal to the area of the second portion P2. By arranging the main body 1031 of the first auxiliary plating 103 at the center of the blank region so that the main body 1031 divides the blank region into the first portion P1 and the second portion P2 having substantially equal areas, the first auxiliary plating 103 can divide the blank region substantially evenly, thereby improving the impact of uneven distribution of lines in the light-emitting region E, alleviating or even eliminating the island effect, and allowing the lines to be distributed in the light-emitting region E as evenly as possible.

The first auxiliary plating 103 may be in various possible shapes, comprising but not limited to an L shape, a T shape, a cross shape, an open-loop structure, an irregular shape, etc. In some embodiments, the first auxiliary plating 103 further comprises a sub-part 1032 extending along a second direction D2 and connected to the main body 1031, the first direction D1 intersects with the second direction D2, for example, the second direction D2 may be the horizontal direction in the figure. In this case, the first auxiliary plating 103 may be an L shape, a T shape, or a cross shape. In an embodiment, as illustrated in Fig. 1, the main body 1031 of the first auxiliary plating 103 comprises a first end 1031A and a second end 1031B opposite to each other in the first direction D1. The first end 1031A is closer to the connection line 102 located in the same light-emitting region E as the first auxiliary plating 103 compared to the second end 1031B, the sub-part 1032 is connected to the second end 1031B of the main body 1031, so that the first auxiliary plating 103 has an L shape. Of course, in alternative embodiments, the first auxiliary plating 103 that satisfies the above-mentioned arrangement may also have a T shape. By arranging the sub-part 1032 of the first auxiliary plating 103 on the side away from the connection line 102, the sub-part 1032 can evenly divide a small blank region at the bottom of the light-emitting region E, which helps to further improve the thickness uniformity of the conductive layer on the light-emitting substrate 100.

In addition, although a method of filling the blank region of the light-emitting region E with the auxiliary plating pattern to achieve an effect proximity to the subtractive method can also balance the impact of the thickness uniformity caused by the electroplating addition process, this method will cause a very large proportion of a single-layer conductive layer, for example, the ratio of the area of the conductive layer to the area of the base substrate is greater than or equal to 85%. The conductive layer with large area and thick thickness has a great influence on the stress of the substrate, and the consumption of additives during the electroplating process is a key factor in restricting the cost of electroplating. A large proportion of the conductive layer means a large consumption of additives, and also means a large consumption of the conductive layer itself, which significantly increases the cost of the electroplating. In the light-emitting substrate 100 provided by the embodiment of the present disclosure, by subtly designing the shape of the first auxiliary plating 103 into an L-shape, a T-shape, or a cross-shape, the conductive layer of the light-emitting substrate 100 can have substantially the same thickness without causing the first auxiliary plating 103 to completely fill the blank region of the light-emitting region E. Under such subtle shape design of the first auxiliary plating 103, the ratio of the area of the conductive layer to the area of the base substrate can be controlled within 30~40%. Compared with the solution of filling the blank region of the light-emitting region E with the auxiliary plating pattern, the cost of the electroplating section can be reduced by more than 50%, which provides a feasible low-cost solution for mass production of the electroplating addition method.

Continuing to refer to Fig. 1, the light-emitting substrate 100 further comprises a plurality of driving voltage signal lines VLED extending along the first direction D1. Each column of light-emitting regions comprises one driving voltage signal line VLED, and multiple connection lines 102 located in the same column are connected to the same driving voltage signal line VLED. In some embodiments, the width of the first auxiliary plating 103 may be the same as the width of the driving voltage signal line VLED. The connection line 102 located in each light-emitting region E and the driving voltage signal line VLED connected to the connection line 102 respectively have a first spacing S1 from the first auxiliary plating 103 located in the light-emitting region E to meet the electrical requirements, for example, to prevent crosstalk. For example, for the i^{th} row and the j^{th} column light-emitting region E at the upper left corner of Fig. 1, the connection line 102 and the first auxiliary plating 103 have the first spacing S1, and the driving voltage signal line VLED and the first auxiliary plating 103 also have the first spacing S1. The value of the first spacing S1 is related to parameters such as the voltage required to drive the light-emitting element 101 and the distance between the driving voltage signal lines VLED. Different products may have different values of the first spacing S1. On the premise of ensuring a safe distance of electricity, the first auxiliary plating 103 should be as close as possible to the connection line 102 and the driving voltage line VLED, that is, the value of the first spacing S1 should be as small as possible, because the closer the first auxiliary plating 103 is to the isolated connection line 102 and driving voltage signal line VLED, the better the auxiliary plating effect is. The value of the first spacing S1 in each light-emitting region E should be consistent. In an embodiment, the voltage required to drive the light-emitting element 101 is about 20V, the safety standard spacing corresponding to this voltage is 200 µm, and the spacing between the driving voltage signal line VLED and other line needs to be greater than or equal to 200 µm, therefore, the first spacing S1 may be designed to be 200 µm. In an alternative embodiment, the voltage required to drive the light-emitting element 101 is about 40V, the safety standard spacing corresponding to this voltage is 400 µm, and the spacing between the driving voltage signal line VLED and other line needs to be greater than or equal to 200 µm, therefore, the first spacing S1 may be designed to be 400 µm.

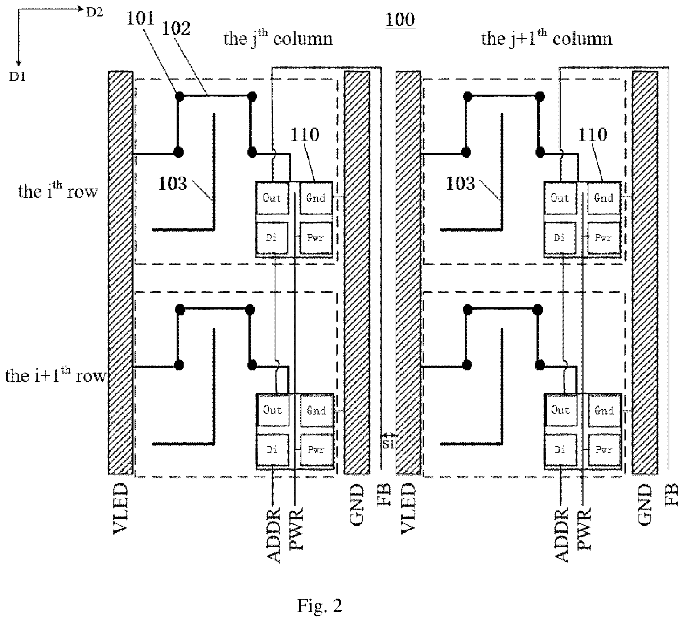

Fig. 2 illustrates a schematic plan view of a partial structure of the light-emitting substrate 100 that is the same as Fig. 1, but Fig. 2 focuses on the layout of various lines and the driving circuit of the light-emitting substrate 100. As illustrated in Fig. 2, the light-emitting substrate 100 also comprises a plurality of driving circuits 110 and a plurality of common voltage signal lines GND extending along the first direction D1. The driving circuit 110 may be an integrated circuit, for example, may be a packaged chip with multiple terminals. The driving circuit 110 may comprise, for example, an address terminal Di, a power terminal Pwr, an output terminal Out, and a ground terminal Gnd. Each light-emitting region E comprises one driving circuit 110, which is connected to the light-emitting elements 101 located in the light-emitting region E. The driving circuits 110 in each column of light-emitting regions are cascaded in sequence. Each column of light-emitting regions comprises one common voltage signal line GND, and the common voltage signal line GND is connected to the ground terminal Gnd of each driving circuit 110 in the column of light-emitting regions. In each column of light-emitting regions, one driving voltage signal line VLED is connected to the light-emitting elements 101 in the column of light-emitting regions via the connection lines 102, and one common voltage signal line GND is connected to the ground terminal Gnd of each driving circuit 110 in the column of light-emitting regions. The driving voltage signal line VLED is configured to provide a driving voltage to the light-emitting element 101, and the common voltage signal line GND is configured to provide a common voltage (e.g., a ground voltage) to the driving circuit 110, for example, when a light-emitting element 101 in a light-emitting region E needs to emit light, by setting the driving voltage as a high voltage and the common voltage as a low voltage, a voltage difference is generated on both sides of the light-emitting element 101, thereby the light-emitting element 101 in the light-emitting region E is driven to emit light.

In some embodiments, as illustrated in Fig. 2, the light-emitting substrate 100 may further comprise a plurality of power signal lines PWR extending along the first direction D1, a plurality of address selection signal lines ADDR extending along the first direction D1, and a plurality of feedback signal lines FB extending along the first direction D1. Each column of light-emitting regions comprises one power signal line PWR, one address selection signal line ADDR, and one feedback signal line FB. The power signal line PWR is connected to the power terminal Pwr of each driving circuit 110 in each column of light-emitting regions, and is configured to provide a power voltage to each driving circuit 110 in each column of light-emitting regions; the address selection signal line ADDR is connected to the address terminal Di of the first cascaded driving circuit 110 in each column of light-emitting regions, and is configured to transmit an address signal to the address terminal Di of the first cascaded driving circuit 110 in each column of light-emitting regions; the feedback signal line FB is connected to the output terminal Out of the last cascaded driving circuit 110 in each column of light-emitting regions, and is configured to receive the signal transmitted by the last cascaded driving circuit 110.

The spacing between the driving voltage signal line VLED in each column of light-emitting regions and the feedback signal line FB in another column of light-emitting regions adjacent to the column of light-emitting regions is equal to the first spacing S1 as mentioned above, and the spacing between the driving voltage signal line VLED and the feedback signal line FB in different two adjacent columns of light-emitting regions should be kept highly consistent. For example, as illustrated in Fig. 2, the spacing between the driving voltage signal line VLED in the (j+1)^{th} column of light-emitting regions and the feedback signal line FB in the j^{th} column of light-emitting regions is equal to the first spacing S1 as mentioned above. In some embodiments, the first spacing is approximately 200 µm. The spacing between adjacent lines in each column of light-emitting regions, such as the spacing between the power signal line PWR and the address selection signal line ADDR, may be smaller than the first spacing S1. In some embodiments, the spacing between the power signal line PWR and the address selection signal line ADDR in each column of light-emitting regions is about 100 µm.

The connection line 102, the first auxiliary plating 103, the driving voltage signal line VLED, the common voltage signal line GND, the power signal line PWR, the address selection signal line ADDR, the feedback signal line FB, the pads of the light-emitting element, and the pads of the driving circuit are arranged in the same layer of the light-emitting substrate 100, and they can be formed from the same conductive layer through the electroplating addition method during the preparation process. The conductive layer may be made of any suitable material, such as copper.

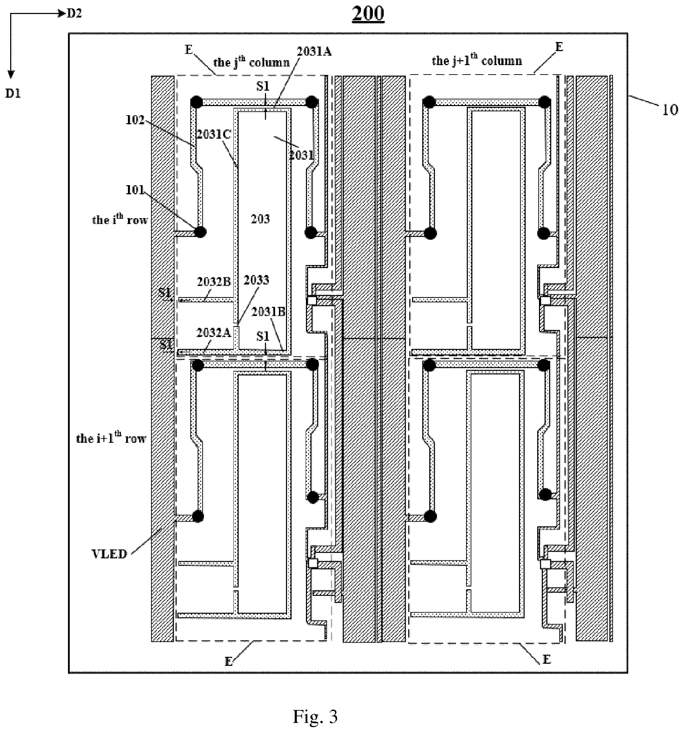

Fig. 3 illustrates a schematic plan view of a partial structure of a light-emitting substrate 200. The light-emitting substrate 200 illustrated in Fig. 3 has substantially the same structure as the light-emitting substrate 100 illustrated in Fig. 1, except for the first auxiliary plating 203, and therefore the same reference numerals are used to refer to the same components. For the sake of simplicity, the similarities between the light-emitting substrate 200 in Fig. 3 and the light-emitting substrate 100 in Fig. 1 will not be described again, and only the differences will be introduced below.

As illustrated in Fig. 3, the light-emitting substrate 200 comprises: a plurality of light-emitting elements 101 located in each of the plurality of light-emitting regions E; a connection line 102 located in each light-emitting region E and configured to connect the light-emitting elements 101 in each light-emitting region E; and a first auxiliary plating 203 located in each light-emitting region E and electrically insulated from the connection line 102 and the light-emitting elements 101. Each light-emitting region E comprises a region occupied by the connection line 102 and a blank region not occupied by the connection line 102. The first auxiliary plating 203 is located in the blank region. The first auxiliary plating 203 comprises a main body 2031 extending along the first direction D1. The main body 2031 divides the blank region into a first portion and a second portion, and the area of the first portion is substantially equal to the area of the second portion. By arranging the main body 2031 of the first auxiliary plating 203 at the center of the blank region so that the main body 2031 divides the blank region into the first portion and the second portion having substantially equal areas, the first auxiliary plating 203 can divide the blank region substantially evenly, thereby improving the impact of uneven distribution of lines in the light-emitting region E and alleviating or even eliminating the island effect, and allowing the lines to be distributed in the light-emitting region E as evenly as possible.

The first auxiliary plating 203 has an open-loop structure. For example, the main body 2031 of the first auxiliary plating 203 is an open rectangular ring. It should be noted that in this application, the term "open-loop structure" means that the shape of the open-loop structure is a non-closed polygon relative to a closed polygon. Since the first auxiliary plating 203 is close to the driving voltage signal line VLED, if the first auxiliary plating 203 has a closed-loop structure, when the surrounding lines of the closed-loop first auxiliary plating 203 (such as the driving voltage signal line VLED, the connection line 102, the common voltage signal line GND, etc.) are energized, the closed-loop structure is affected by the current of the surrounding lines to couple the signal, thus affecting the voltage of the surrounding lines and producing electromagnetic crosstalk (EMI). By designing the main body 2031 of the first auxiliary plating 203 into the open-loop structure, electromagnetic crosstalk can be avoided.

As illustrated in Fig. 3, the first auxiliary plating 203 also comprises two sub-parts extending along the second direction D2 and connected to the main body 2031, namely a first sub-part 2032A and a second sub-part 2032B. The main body 2031 comprises a first edge 2031A and a second edge 2031B opposite to each other in the first direction D1 and a side edge 2031C connecting the first edge 2031A and the second edge 2031B. The first edge 2031A is closer to the connection line 102 located in the same light-emitting region E as the first auxiliary plating 203 compared to the second edge 2031B. The opening 2033 of the rectangular ring is located at the side edge 2031C so that the rectangular ring is an open-loop. The first sub-part 2032A is connected to the second edge 2031B and the side edge 2031C of the main body 2031. The second sub-part 2032B is connected to the side edge 2031C of the main body 2031 and is closer to the second edge 2031B compared to the first edge 2031A, and the opening 2033 is located between the first sub-part 2032A and the second sub-part 2032B. By arranging the two sub-parts 2032A and 2032B of the first auxiliary plating 203 on the side away from the connection line 102, the two sub-parts can evenly divide a small blank region at the bottom of the light-emitting region E, which helps to further improve the thickness uniformity of the conductive layer on the light-emitting substrate 200.

The minimum spacing between the first edge 2031A of the main body 2031 of the first auxiliary plating 203 and the connection line 102 in the light-emitting region E is the first spacing S1. It should be noted that the "minimum spacing" here refers to the spacing between the first edge 2031A of the first auxiliary plating 203 and the portion of the connection line 102 closest to the first edge 2031A. The minimum spacing between the second edge 2031B of the main body 2031 of the first auxiliary plating 203 and the connection line 102 in the adjacent light-emitting region E is the first spacing S1. Similarly, the "minimum spacing" here refers to the spacing between the second edge 2031B of the first auxiliary plating 203 and the portion of the connection line 102 in the adjacent light-emitting region E that is closest to the second edge 2031B. The spacing between the two sub-parts 2032A and 2032B of the first auxiliary plating 203 and the driving voltage signal line VLED is the first spacing S1 respectively. In some embodiments, the first spacing S1 is approximately 200 µm.

In the light-emitting substrate 200 provided by the embodiment of the present disclosure, by subtly designing the shape of the first auxiliary plating 203, the thickness uniformity of the conductive layer of the light-emitting substrate 200 can be improved without causing the first auxiliary plating 203 to completely fill the blank region of the light-emitting region E. Under such subtle shape design of the first auxiliary plating 203, the ratio of the area of the conductive layer to the area of the base substrate can be controlled within 30~40%. Compared with the solution of filling the blank region of the light-emitting region E with the auxiliary plating pattern, the cost of the electroplating section can be reduced by more than 50%, which provides a feasible low-cost solution for mass production of the electroplating addition method.

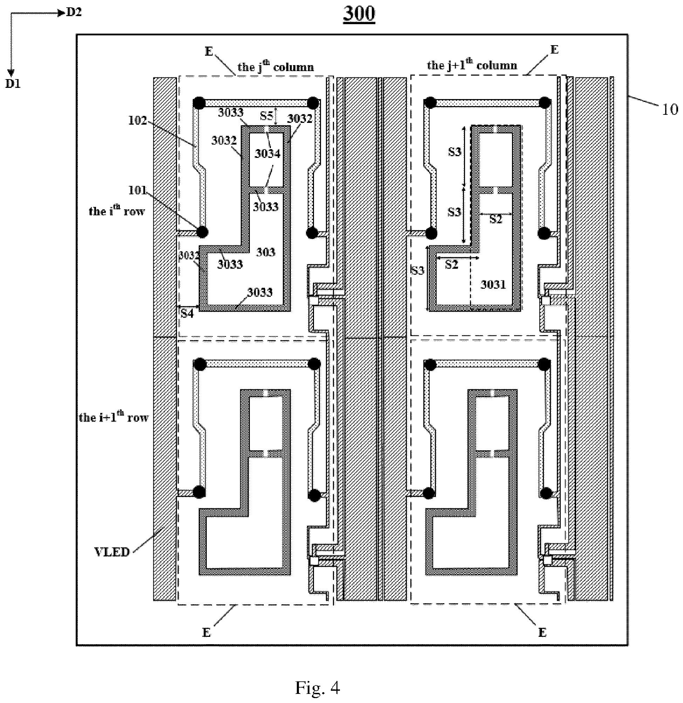

Fig. 4 illustrates a schematic plan view of a partial structure of a light-emitting substrate 300. Except for the first auxiliary plating 303, the light-emitting substrate 300 illustrated in Fig. 4 has substantially the same structure as the light-emitting substrate 100 illustrated in Fig. 1, and therefore, the same reference numerals are used to refer to the same components. For the sake of simplicity, the similarities between the light-emitting substrate 300 in Fig. 4 and the light-emitting substrate 100 in Fig. 1 will not be described again, and only the differences will be introduced below.

As illustrated in Fig. 4, the light-emitting substrate 300 comprises: a plurality of light-emitting elements 101 located in each of the plurality of light-emitting regions E; a connection line 102 located in each light-emitting region E and configured to connect the light-emitting elements 101 in each light-emitting region E; and a first auxiliary plating 303 located in each light-emitting region E and electrically insulated from the connection line 102 and the light-emitting elements 101. The overall outer contour of the first auxiliary plating 303 is an L-shaped ring. Each light-emitting region E comprises a region occupied by the connection line 102 and a blank region not occupied by the connection line 102. The first auxiliary plating 303 is located in the blank region. The first auxiliary plating 303 comprises a main body 3031 (for example, a partial structure of the first auxiliary plating 303 enclosed by a dotted rectangular frame in the i^{th} row and the (j+1)^{th} column) extending along the first direction D1. The main body 3031 divides the blank region into a first portion and a second portion, and the area of the first portion is substantially equal to the area of the second portion. By arranging the main body 3031 of the first auxiliary plating 303 at the center of the blank region so that the main body 3031 divides the blank region into the first portion and the second portion having substantially equal areas, the first auxiliary plating 303 can divide the blank region substantially evenly, thereby improving the impact of uneven distribution of lines in the light-emitting region E, alleviating or even eliminating the island effect, and allowing the lines to be distributed in the light-emitting region E as evenly as possible.

The first auxiliary plating 303 has an open-loop structure to prevent electromagnetic crosstalk to surrounding lines. The first auxiliary plating 303 comprises three third sub-parts 3032 extending along the first direction D1 and four fourth sub-parts 3033 extending along the second direction D2, two of the four fourth sub-parts 3033 comprise openings 3034, and the third sub-parts 3032 and the fourth sub-parts 3033 are connected so that the outline of the first auxiliary plating 303 is formed into an L-shaped open-loop structure. Any two adjacent third sub-parts 3032 among the three third sub-parts 3032 have a substantially equal spacing S2, which allows the first auxiliary plating 303 to evenly divide the blank region along the first direction D1. Any two adjacent fourth sub-parts 3033 among the four fourth sub-parts 3033 have a substantially equal spacing S3, which allows the first auxiliary plating 303 to evenly divide the blank region along the second direction D2. By evenly dividing the blank region in the horizontal and vertical directions, the impact of uneven distribution of lines in the light-emitting region E can be further improved, the island effect can be alleviated or even eliminated, and the lines can be distributed as evenly as possible in the light-emitting region E.

Different from the first auxiliary plating 103, the spacing between the first auxiliary plating 303 located in each light-emitting region E and the driving voltage signal line VLED located in the same column of light-emitting regions as the first auxiliary plating 303 is S4, and the spacing between the first auxiliary plating 303 located in each light-emitting region E and the connection line 102 located in the light-emitting region E is S5. The spacing S4 and the spacing S5 may be same or different, but both are larger than the first spacing S1.

In the light-emitting substrate 300 provided by the embodiment of the present disclosure, by subtly designing the shape of the first auxiliary plating 303, the thickness uniformity of the conductive layer of the light-emitting substrate 300 can be improved without causing the first auxiliary plating 303 to completely fill the blank region of the light-emitting region E. Under such subtle shape design of the first auxiliary plating 303, the ratio of the area of the conductive layer to the area of the base substrate can be controlled within 30~40%. Compared with the solution of filling the blank region of the light-emitting region E with the auxiliary plating pattern, the cost of the electroplating section can be reduced by more than 50%, which provides a feasible low-cost solution for mass production of the electroplating addition method.

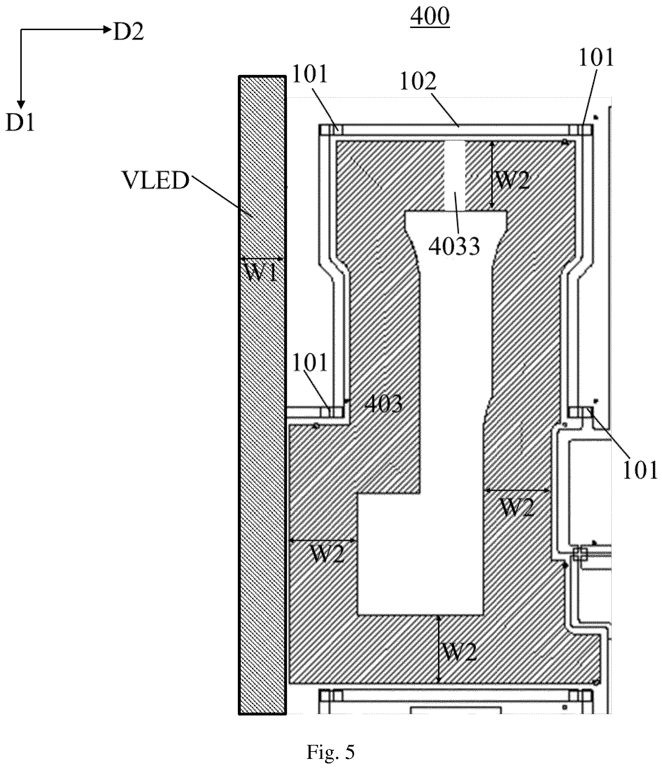

Fig. 5 illustrates a schematic plan view of a partial structure in a light-emitting region E of a light-emitting substrate 400. The light-emitting substrate 400 illustrated in Fig. 5 has substantially the same structure as the light-emitting substrate 100 illustrated in Fig. 1 except for the first auxiliary plating 403, and therefore, the same reference numerals are used to refer to the same components. For the sake of simplicity, the similarities between the light-emitting substrate 400 in Fig. 5 and the light-emitting substrate 100 in Fig. 1 will not be described again, and only the differences will be introduced below.

As illustrated in Fig. 5, the light-emitting substrate 400 comprises: a plurality of light-emitting elements 101 located in each of the plurality of light-emitting regions E; a connection line 102 located in each light-emitting region E and configured to connect the light-emitting elements 101 in each light-emitting region E; and a first auxiliary plating 403 located in each light-emitting region E and electrically insulated from the connection line 102 and the light-emitting element 101. Each light-emitting region E comprises a region occupied by the connection line 102 and a blank region not occupied by the connection line 102. The first auxiliary plating 403 is located in the blank region.

The first auxiliary plating 403 comprises an opening 4033, so that the first auxiliary plating 403 has an open-loop structure, thereby preventing electromagnetic crosstalk to surrounding lines. The width W2 of the first auxiliary plating 403 is greater than or equal to the width W1 of the driving voltage signal line VLED. In some embodiments, the width W2 of the first auxiliary plating 403 may be 1 to 10 times the width W1 of the driving voltage signal line VLED. The wider the width W2 of the first auxiliary plating 403, the better the auxiliary plating effect, the thickness of the conductive layer where the first auxiliary plating 403 is located is closer to the thickness of the entire coating, but accordingly, the proportion of the conductive layer will increase. Therefore, the width W2 of the first auxiliary plating 403 should be controlled within a reasonable range. The spacing between the first auxiliary plating 403 and the connection line 102 and the spacing between the first auxiliary plating 403 and the driving voltage signal line VLED may be equal to the first spacing S1. In some embodiments, the first spacing S1 may be approximately equal to 200 µm.

In the light-emitting substrate 400 provided by the embodiment of the present disclosure, by subtly designing the shape of the first auxiliary plating 403, the thickness uniformity of the conductive layer of the light-emitting substrate 400 can be improved without causing the first auxiliary plating 403 to completely fill the blank region of the light-emitting region E. Under such subtle shape design of the first auxiliary plating 403, the ratio of the area of the conductive layer to the area of the base substrate can be controlled within 30~40%. Compared with the solution of filling the blank region of the light-emitting region E with the auxiliary plating pattern, the cost of the electroplating section can be reduced by more than 50%, which provides a feasible low-cost solution for mass production of the electroplating addition method.

Figs. 1 to 5 illustrate various shapes of first auxiliary platings as examples, and the specific shapes may vary according to the design of lines in the main lamp region of different projects. The first auxiliary plating either divides the blank region evenly (for example, the first auxiliary platings 103, 203, 303) or is arranged around the blank region (for example, the first auxiliary plating 403), but is as close as possible to the connection line 102. By providing the first auxiliary plating, the lines can be distributed as evenly as possible in the light-emitting region E, thereby alleviating or even eliminating the influence of uneven thickness of layer caused by the uneven distribution of island lines in the light-emitting region E, controlling the ratio of the area of the conductive layer to the area of the base substrate within 30-40%, and significantly reducing the cost of the electroplating section.

It should be noted that the entire light-emitting substrate may adopt a first auxiliary plating with the same shape, or may adopt a combination of first auxiliary platings with different shapes, and the specific arrangement can be flexibly changed according to needs. For example, the display region of the light-emitting substrate may adopt a first auxiliary plating of one shape, and the non-display region surrounding the display region of the light-emitting substrate may adopt a first auxiliary plating of another shape.

In some embodiments, the first auxiliary plating (e.g. 103, 203, 303, 403) described in any of the previous embodiments is in the same layer as the driving voltage signal line VLED. In some alternative embodiments, the first auxiliary plating (e.g. 103, 203, 303, 403) described in any of the previous embodiments, the driving voltage signal line VLED, and the connection line 102 are in the same layer. It should be noted that in this application, the term "A is in the same layer as B" means that A and B are made in one process. Similarly, the term "A, B, and C are in the same layer" means that A, B, and C are made in one process.

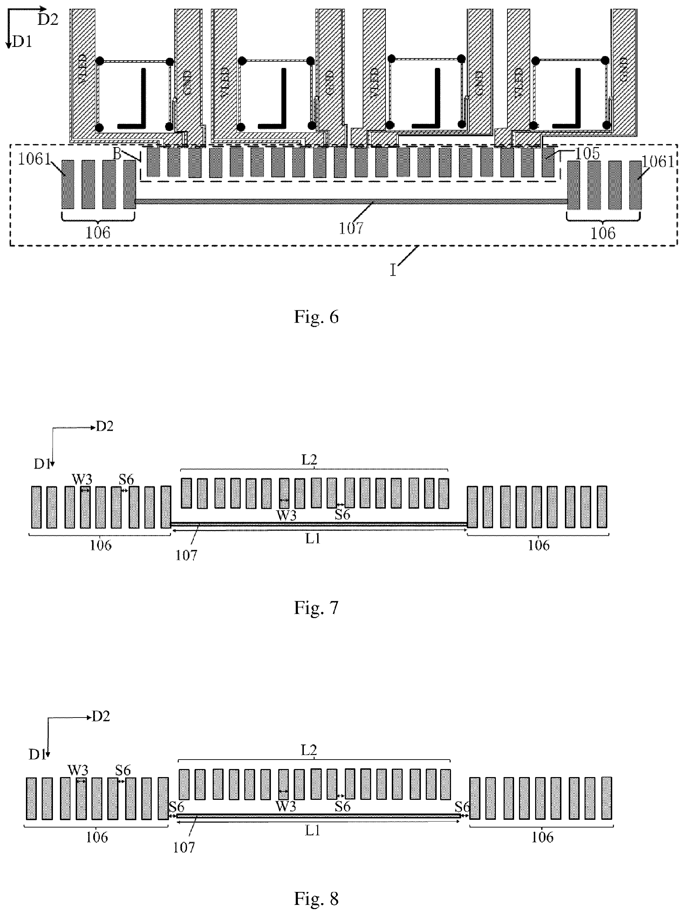

Fig. 6 illustrates the arrangement of the bonding region of a light-emitting substrate. The light-emitting substrate illustrated in Fig. 6 may be any one of the light-emitting substrate 100, 200, 300, or 400 described in the previous embodiments. As illustrated in the figure, the light-emitting substrate also comprises: a bonding region B; a plurality of bonding electrodes 105 located in the bonding region B; and a second auxiliary plating 106 located on both sides of the plurality of bonding electrodes 105 in the second direction D2. The second auxiliary plating 106 is electrically insulated from the plurality of bonding electrodes 105. Since the lines in the fan-out region above the bonding region B are dense, if the second auxiliary plating 106 is not provided near the bonding electrode 105, the thickness of the bonding electrodes 105 in the bonding region B will be inconsistent with the thickness of the lines in the fan-out region. It is beneficial to keep the thickness of the bonding electrodes 105 consistent with the thickness of the lines in the fan-out region by arranging the second auxiliary plating 106 on both sides of the bonding electrodes 105.

Fig. 7 is an enlarged view of the region I in Fig. 6. As illustrated in Figs. 6 and 7, the second auxiliary plating 106 comprises a plurality of auxiliary electrodes 1061, the width W3 of each auxiliary electrode 1061 along the second direction D2 is equal to the width W3 of each bonding electrode 105 along the second direction D2, and the spacing S6 between any two adjacent auxiliary electrodes 1061 among the plurality of auxiliary electrodes 1061 is equal to the spacing S6 between any two adjacent bonding electrodes 105 among the plurality of bonding electrodes 105. Since the lines on the light-emitting substrate are formed from the same conductive layer, keeping the width and spacing of the bonding electrode 105 and the auxiliary electrode 1061 consistent is beneficial to process implementation.

In some embodiments, the second auxiliary plating 106 and the driving voltage signal line VLED are in the same layer. In some alternative embodiments, the second auxiliary plating 106, the driving voltage signal line VLED, the connection line 102, and the bonding electrode 105 are in the same layer. As mentioned before, terms such as "A and B are in the same layer" mean that A and B are made in one process. In some embodiments, as illustrated in Figs. 6 and 7, the light-emitting substrate may further comprise a third auxiliary plating 107 located on the side of the plurality of bonding electrodes 105 away from the light-emitting region E and electrically insulated from the plurality of bonding electrodes 105. The third auxiliary plating 107 is a strip shape, and the length L1 of the third auxiliary plating 107 along the second direction D2 is greater than the length L2 spanned by the plurality of bonding electrodes 105 along the second direction D2, which allows the third auxiliary plating 107 to surround the plurality of bonding electrodes 105. Arranging the third auxiliary plating 107 on the side of the bonding electrode 105 away from the light-emitting region E helps to further keep the thickness of the bonding electrodes 105 consistent with the thickness of the lines in the fan-out region.

The third auxiliary plating 107 and the bonding electrode 105 have an appropriate spacing in the first direction D1, so as to avoid the risk of short circuit among the bong electrodes 105 caused by the contact between the third auxiliary plating 107 and the bonding electrode 105 due to the bonding offset accuracy. In some embodiments, the spacing between the third auxiliary plating 107 and the bonding electrode 105 may be 0.6 mm.

As illustrated in Fig. 7, the third auxiliary plating 107 may be connected with the second auxiliary plating 106, that is, one end of the third auxiliary plating 107 is in contact and connected with the second auxiliary plating 106, and the other end of the third auxiliary plating 107 is in contact and connected with the other second auxiliary plating 106. In an alternative embodiment, as illustrated in Fig. 8, the third auxiliary plating 107 may not be connected with the second auxiliary plating 106. In this case, there is a spacing between the third auxiliary plating 107 and the second auxiliary plating 106. In some embodiments, the spacing may be equal to the spacing S6 between any two adjacent bonding electrodes 105 among the plurality of bonding electrodes 105.

It should be noted that when the shape of the light-emitting substrate is a regular rectangle, the shape of the light-emitting region (or referred to as the lamp region) and the shapes of various auxiliary platings may be designed as described in the previous embodiments. However, the shapes of the light-emitting region and various auxiliary platings described in the above embodiments may be flexibly changed according to the specific shape of the light-emitting substrate. For example, when the shape of the light-emitting substrate is a special shape, such as when the four corners of the light-emitting substrate are arc corners, the shapes of the light-emitting region and the auxiliary plating can be deformed accordingly to adapt to the special-shaped light-emitting substrate.

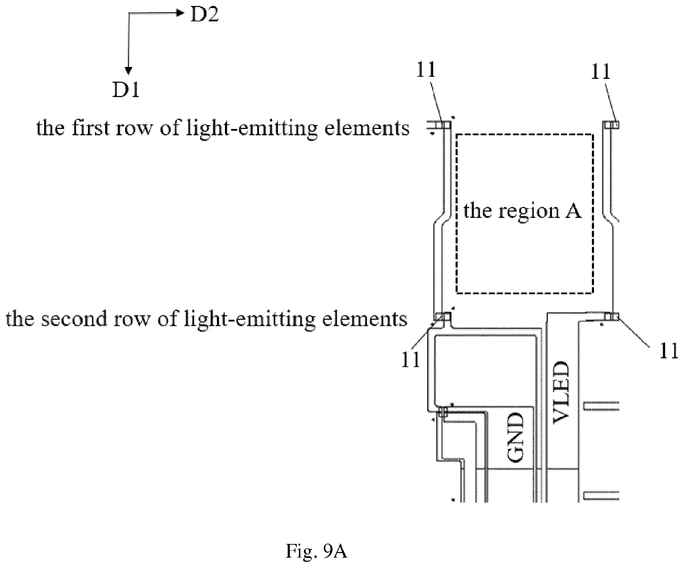

Fig. 9A illustrates a schematic plan view of a partial structure of a light-emitting substrate in the related art, illustrating four light-emitting elements 11. The four light-emitting elements 11 are arranged in two rows and two columns, with two light-emitting elements 11 located in the first row and the other two light-emitting elements 11 located in the second row. The inventor(s) of the present application found that in the related art, the functional line is at most flush with the second row of light-emitting elements 11 and does not extend to the first row of light-emitting elements 11. For example, the driving voltage signal line VLED is connected to the second row of light-emitting elements 11 and its end is flush with the second row of light-emitting elements 11, while the end of the common voltage signal line GND does not reach the second row of light-emitting elements 11. This causes the region where the first row of light-emitting elements 11 are located, for example, the region A in the figure, to become a large blank region without line, thereby causing the pad thickness of the first row of light-emitting elements 11 to be significantly larger than the pad thickness of other rows of light-emitting elements 11 after electroplating. For example, the pad thickness of the second row of light-emitting elements 11 to the last row of light-emitting elements 11 is about 6 µm and meets the design requirement. While the pad thickness of the first row of light-emitting elements 11 is about 14 µm and seriously beyond the range that the solder paste can cover, resulting in the inability to bond the light-emitting elements 11 to the pads normally and the inability to normally emit light for the first row of light-emitting elements on the light-emitting substrate.

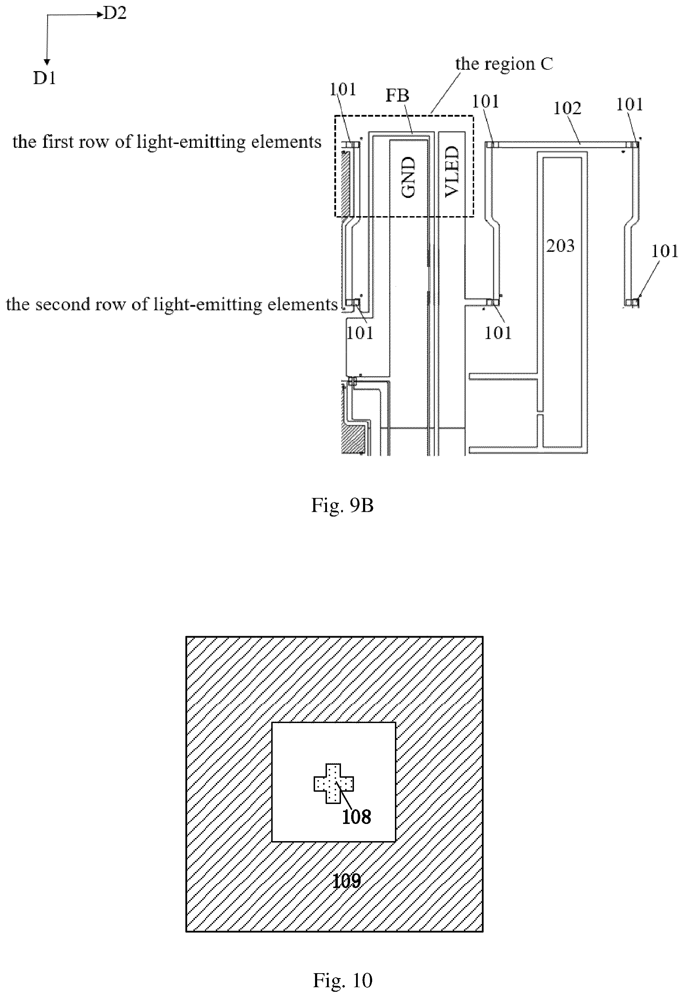

Fig. 9B illustrates a schematic plan view of a partial structure of a light-emitting substrate according to an embodiment of the present disclosure, which illustrates two rows of light-emitting elements, namely a first row of light-emitting elements and a second row of light-emitting elements. The light-emitting substrate illustrated in Fig. 9B may be the light-emitting substrate described in any of the previous embodiments. In the light-emitting substrates provided by embodiments of the present disclosure, the functional lines extend beyond the first row of light-emitting elements 101 in the first direction D1 or are at least flush with the first row of light-emitting elements 101. For example, as illustrated in Fig. 9B, the end of the common voltage signal line GND is at least flush with the first row of light-emitting elements 101 in the first direction D1, and the driving voltage signal line VLED and the feedback signal line FB both extend beyond the first row of light-emitting elements 101 in the first direction D1. The functional lines are routed to the first row of light-emitting elements 101 or beyond the first row of light-emitting elements 101 by pulling up them, the original blank region can comprise evenly arranged lines, as illustrated in the region C of Fig. 9B. Therefore, the pad thickness of the first row of light-emitting elements 101 is substantially consistent with the pad thickness of other rows of light-emitting elements 101, and the entire light-emitting substrate can emit light uniformly.

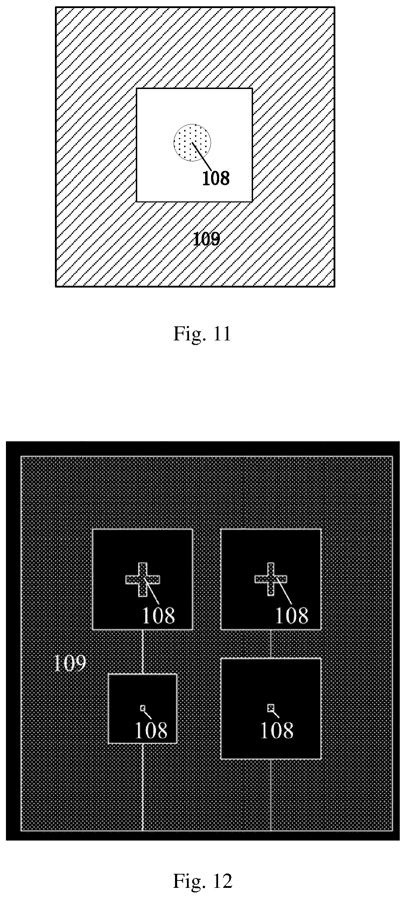

Fig. 10 illustrates a schematic diagram of a partial structural of a light-emitting substrate. The light-emitting substrate may be the light-emitting substrate described in any of the previous embodiments. As illustrated in Fig. 10, the light-emitting substrate may further comprise: an alignment mark 108; and an annular auxiliary plating 109 surrounding the alignment mark 108 and electrically insulated from the alignment mark 108. The alignment mark 108 is a mark used to assist in aligning the film during the process, and it is usually arranged in a region without lines on the base substrate, for example, it can be provided at the process edge of the light-emitting substrate and/or at the effective edge of the light-emitting substrate. The term "effective edge" refers to the edge of the light-emitting substrate in the finished product state, the term "process edge" refers to the product outline boundary that plays a supporting role due to the need for process capabilities during the production process. The process edge is on the periphery of the effective edge and is usually larger than the effective edge. The process edge may be used to place alignment marks required for processes such as white oil printing, electroless gold plating, cutting, etc. After the preparation process, the process edge can be cut off so that the light-emitting substrate presents the effective edge. The alignment mark 108 may be in various appropriate shapes. For example, the alignment mark 108 illustrated in Fig. 10 is a cross shape, the alignment mark 108 illustrated in Fig. 11 is a circular shape, and the alignment mark 108 illustrated in Fig. 12 is a cross shape or square shape. In some embodiments, the width of the annular auxiliary plating 109 is 0.2~5.0 mm, and the spacing between the annular auxiliary plating 109 and the alignment mark 108 is 0.02~0.5 mm.

By arranging annular auxiliary platings 109 around all the alignment marks 108, the thickness of the island alignment marks 108 can be prevented from being too thick and can be kept substantially the same as the thickness of the conductive layer in the light-emitting region E of the light-emitting substrate, so that the grasping and identification of the alignment mark 108 in the subsequent process can be performed normally.

In some embodiments, one annular auxiliary plating 109 surrounds one alignment mark 108, as illustrated in Fig. 10 or Fig. 11. In alternative embodiments, one annular auxiliary plating 109 surrounds a plurality of alignment marks 108, as illustrated in Fig. 12.

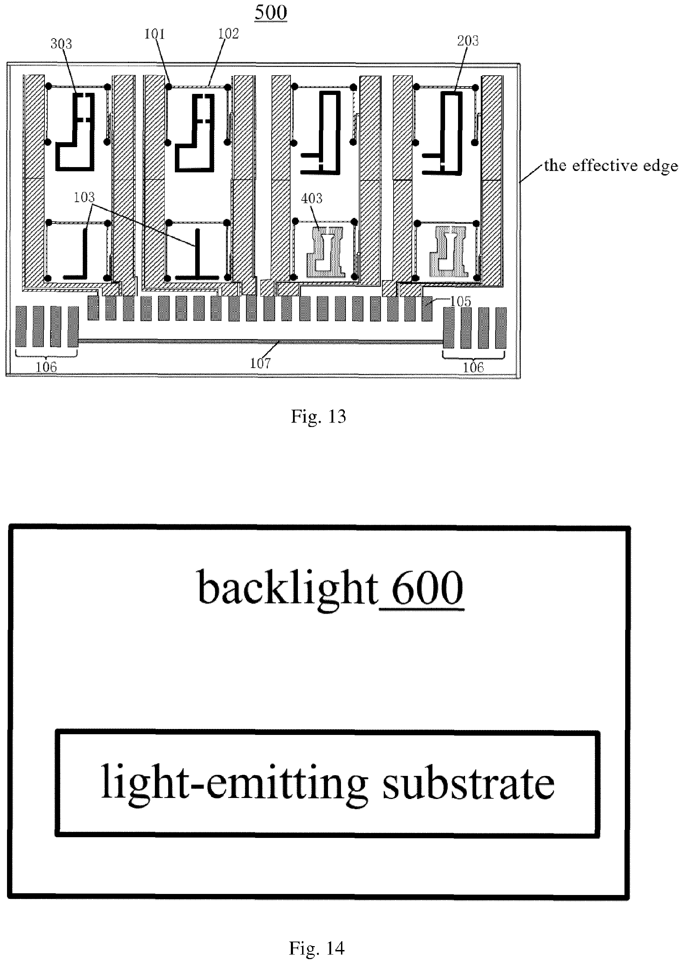

Fig. 13 illustrates a schematic plan view of a partial structure of a light-emitting substrate 500. As mentioned above, during the preparation of the light-emitting substrate, the surroundings of the light-emitting substrate comprise process edges. In some embodiments, during preparation, fourth auxiliary platings with strip shape may be formed on the four process edges respectively, and the orthographic projections of the four process edges on the base substrate respectively fall within the orthographic projections of the four fourth auxiliary platings on the base substrate. After the relevant preparation process, four process edges may be cut off. By arranging fourth auxiliary platings with strip shape on four process edges, the fourth auxiliary platings may cover the entire periphery of the light-emitting substrate 500, which is beneficial to improving the thickness uniformity of the conductive layer at the periphery of the light-emitting substrate.

Although the designs of the auxiliary platings in different regions of the light-emitting substrate are described above with different drawings, the designs of the auxiliary platings in different regions can be integrated into the same light-emitting substrate. As illustrated in Fig. 13, the light-emitting region of the light-emitting substrate 500 may be provided with the first auxiliary plating 103/203/303/403 as described above, the bonding region of the light-emitting substrate 500 may be provided with the second auxiliary plating 106 and the third auxiliary plating 107 as mentioned above, the fourth auxiliary plating may be provided on the four process edges, and the annular auxiliary plating may be provided around the alignment mark. By arranging these auxiliary platings, the conductive layers in various region of the light-emitting substrate 500 can have a substantially consistent thickness.

Fig. 14 illustrates a block diagram of a backlight 600 comprising the light-emitting substrate described in any of the previous embodiments. The backlight 600 may be used as a backlight in a display device to provide a display light source for a display panel in the display device. Of course, the backlight 600 may also be used in any other device that requires a light source. The embodiments of the present disclosure do not specifically limit the use of the backlight 600.

Since the backlight 600 can have substantially the same technical effects as the light-emitting substrate described in the previous embodiments, for the purpose of brevity, the technical effects of the backlight 600 will not be described again.

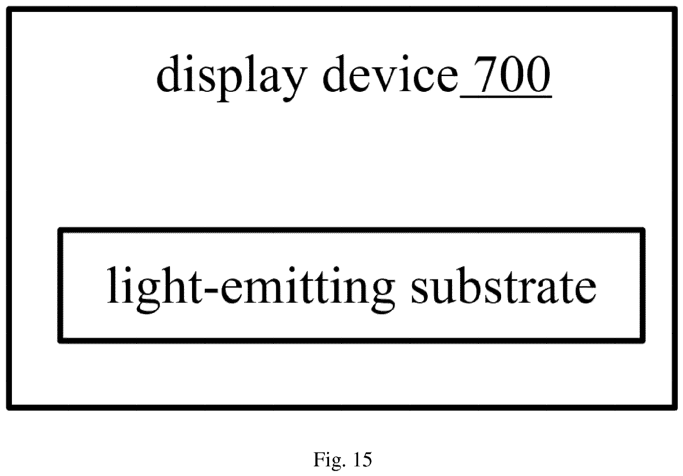

Fig. 15 illustrates a block diagram of a display device 700 comprising the light-emitting substrate described in any of the previous embodiments. In some embodiments, the display device 700 may be a liquid crystal display device, which comprises a liquid crystal panel and a backlight disposed on a non-display side of the liquid crystal panel, the backlight comprises the light-emitting substrate described in any of the previous embodiments and may be used, for example, to implement HDR dimming for display operations. The liquid crystal display device can have more uniform backlight brightness and better display contrast. The display device 700 may be any appropriate display device, comprising but not limited to any product or component with a display function, such as a mobile phone, a tablet computer, a television, a monitor, a notebook computer, a digital photo frame, a navigator, or an e-book.

Since the display device 700 can have substantially the same technical effects as the light-emitting substrate described in the previous embodiments, for the purpose of brevity, the technical effects of the display device 700 will not be described again.

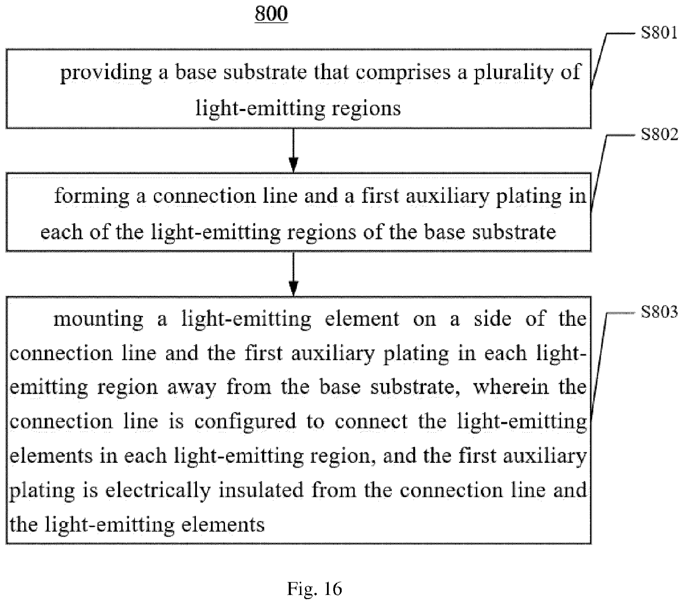

Fig. 16 illustrates a flow chart of a method 800 for preparing a light-emitting substrate. The method 800 is applicable to the light-emitting substrate described in any of the previous embodiments. Taking the light-emitting substrate 100 illustrated in Fig. 1 as an example, the method 800 may comprise the following steps:
S801: providing a base substrate 10 which comprises a plurality of light-emitting regions E.
S802: forming a connection line 102 and a first auxiliary plating 103 in each light-emitting region E of the base substrate 10.
S803: mounting a light-emitting element 101 on a side of the connection line 102 and the first auxiliary plating 103 in each light-emitting region E away from the base substrate 10, the connection line 102 being configured to connect the light-emitting elements 101 in each light-emitting region E, and the first auxiliary plating 103 being electrically insulated from the connection line 102 and the light-emitting element 101.

As illustrated in Fig. 1, if the light-emitting substrate 100 is not provided with the first auxiliary plating 103, there will be almost no other signal lines near the connection line 102 in the light-emitting region E, and a large blank region will appear near the connection line 102, causing the connection line 102 to become an island line. In addition, the width of the signal line VLED is significantly larger than the width of the connection line 102. Such uneven width and uneven distribution of lines bring great challenges to the electroplating addition method. Therefore, the thickness of the connection line 102 formed by the electroplating addition method will be significantly larger than the thickness of other signal lines on the light-emitting substrate 100, which is not conducive to the realization of thickness uniformity. In the embodiment of the present disclosure, by setting the first auxiliary plating 103 in the light-emitting region E, the distribution of lines in the light-emitting region E is more uniform, the island effect of the connection line 102 is improved, thereby reducing or even avoiding the impact of the island effect on the electroplating uniformity, making the thickness of the connection line 102 basically consistent with the thickness of other signal lines on the light-emitting substrate 100, improving the thickness uniformity of lines on the light-emitting substrate 100. When the light-emitting element 101 is bonded to the light-emitting substrate 100, the cathode pad and the anode pad of the light-emitting element 101 have substantially the same height, thereby ensuring that each light-emitting element 101 is firmly bonded to the pad, so that the light-emitting substrate 100 has a uniform light-emitting effect.

In some embodiments, the light-emitting substrate further comprises a bonding region B, and the step S802 may also comprise the following sub-steps: applying a conductive layer on the base substrate 10 and patterning the conductive layer to simultaneously form signal lines, the connection line 102 and the first auxiliary plating 103 located in the light-emitting region E, a plurality of bonding electrodes 105 located in the bonding region B, the second auxiliary plating 106, the third auxiliary plating 107, pads of the light emitting element, and pads of the driving circuit. The signal lines extend along the first direction D1 and comprise the driving voltage signal line VLED, the common voltage signal line GND, the power signal line PWR, the address selection signal line ADDR, and the feedback signal line FB. Each column of light-emitting regions comprises one driving voltage signal line VLED, one common voltage signal line GND, one power signal line PWR, one address selection signal line ADDR, and one feedback signal line FB. The second auxiliary plating 106 is located on both sides of the plurality of bonding electrodes 105 in the second direction D2 and is electrically insulated from the plurality of bonding electrodes 105. The second direction D2 intersects with the first direction D1, for example, the first direction D1 is the vertical direction in the figure, and the second direction D2 is the horizontal direction in the figure. The third auxiliary plating 107 is located on a side of the plurality of bonding electrodes 105 away from the light-emitting region E and is electrically insulated from the plurality of bonding electrodes 105. The third auxiliary plating 107 is in a strip shape, and the length L1 of the third auxiliary plating 107 along the second direction D2 is greater than the length L2 spanned by the plurality of bonding electrodes 105 along the second direction D2. The third auxiliary plating 107 may be connected to the second auxiliary plating 106, or may not be connected to the second auxiliary plating 106.

The connection line 102, the first auxiliary plating 103, the driving voltage signal line VLED, the common voltage signal line GND, the power signal line PWR, the address selection signal line ADDR, the feedback signal line FB, pads of the light-emitting element, and pads of the driving circuit are formed from the same conductive layer through a mask. The conductive layer may be made of any suitable material, such as copper. In the related art, the above-mentioned lines are usually formed from two conductive layers. Compared with the double-layer conductive layer process, the single-layer conductive layer process provided by the embodiments of the present disclosure is more optimized and has lower cost.

In some embodiments, the method 800 may further comprise: forming a fourth auxiliary plating with a strip shape on the four process edges of the base substrate, orthographic projections of the four process edges on the base substrate respectively fall within orthographic projections of four fourth auxiliary platings on the base substrate; and cutting off the four process edges. By arranging the fourth auxiliary plating with the strip shape on four process edges, the fourth auxiliary plating can cover the entire periphery of the light-emitting substrate, which is beneficial to improving the thickness uniformity of the conductive layer at the periphery of the light-emitting substrate.

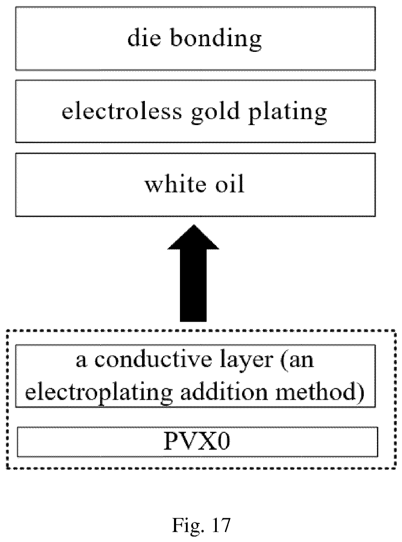

Fig. 17 illustrates a more detailed schematic diagram of a method of preparing a light-emitting substrate, which method will be described below with reference to Fig. 17.

S901: preparing a buffer layer PVX0 on the base substrate through a sputtering process. The buffer layer PVX0 can reduce the impact of the conductive layer on the stress of the base substrate in the next step of the process, thereby reducing the warpage of the base substrate. The base substrate may be a glass substrate, for example.

S902: preparing a first conductive layer on the buffer layer PVX0 through the sputtering process. The first conductive layer may be used as a seed layer for subsequent electroplating of a thick conductive layer. The first conductive layer may be a copper layer.

S903: forming a patterned photoresist on a side of the first conductive layer away from the base substrate through processes such as coating, photolithography, and development to serve as a barrier for subsequent formation of a second conductive layer.

S904: forming the second conductive layer on the surface of the first conductive layer that is not shielded by the photoresist by using an electroplating addition method. The thickness of the second conductive layer is greater than the thickness of the first conductive layer. The second conductive layer may be a copper layer.

S905: stripping the photoresist to expose the first conductive layer.

S906: etching the exposed first conductive layer through an etching process to form a patterned conductive layer. The patterned conductive layer may comprise the connection line 102, the first auxiliary plating 103, the driving voltage signal line VLED, the common voltage signal line GND, the power signal line PWR, the address selection signal line ADDR, the feedback signal line FB, pads of the light-emitting element, and pads of the driving circuit as mentioned above.

Steps S901 to S906 can be implemented by using a mask. Compared with use of two masks in the traditional method, the process of using one mask is more optimized and the cost is lower. The patterned second conductive layer formed by this new electroplating addition method can control the ratio of the area of the second conductive layer to the area of the base substrate within 30~40%. Compared with the solution of filling the blank region of the light-emitting region E with the auxiliary plating pattern, the cost of the electroplating section can be reduced by more than 50%, which provides a feasible low-cost solution for mass production of the electroplating addition method.

S907: white oil process. Specifically, an insulating layer is formed on a side of the second conductive layer away from the base substrate. This insulating layer can prevent the exposed second conductive layer from oxidizing. The insulating layer may be any suitable material, such as white oil.

S908: electroless nickel immersion gold process. Specifically, a metal plating layer is formed on the surface of the insulating layer away from the base substrate through a chemical oxidation-reduction reaction. The metal plating layer can protect the exposed second conductive layer in the region that is not covered by the insulating layer (such as the region where the pads of the light-emitting element and the pads of the driving circuit are disposed) from being oxidized.

S909: die bonding process. Bonding the light-emitting elements 101 to the corresponding pads on the light-emitting substrate.

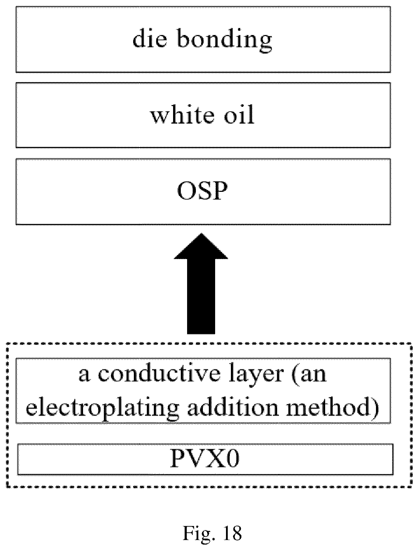

Fig. 18 illustrates a schematic diagram of another method for preparing a light-emitting substrate. The method is basically the same as the method illustrated in Fig. 17, and only differs in some steps. For the sake of simplicity, only the differences between the method in Fig. 18 and the method in Fig. 17 will be introduced below, and the similarities may refer to the description of Fig. 17.

The patterned first conductive layer, the photoresist, and the second conductive layer are formed using exactly the same method as steps S901 to S906.

S907': organic solderability preservatives (OSP) process. Specifically, an organic protection soldering film is formed on a side of the second conductive layer away from the base substrate. The organic protection soldering film can protect the second conductive layer and prevent the exposed second conductive layer from oxidation. In the subsequent high temperature of soldering, the organic protection soldering film can be removed by flux, so that the exposed second conductive layer quickly combines with the molten solder to form a stable solder joint.

S908': white oil process, specifically, an insulating layer is formed on a side of the organic protection soldering film away from the base substrate. This insulating layer can further protect the second conductive layer and prevent it from being oxidized. The insulating layer may be any suitable material, such as white oil.

S909': die bonding process. Bonding the light-emitting elements 101 to the corresponding pads on the light-emitting substrate.

It will be understood that although the terms first, second, third, etc. may be used herein to describe various elements, components, regions, layers and/or portions, these elements, components, regions, layers and/or portions should not be limited by these terms. These terms are only used to distinguish an element, component, region, layer or portion from another element, component, region, layer or portion. Thus, a first element, component, region, layer or portion discussed above could be termed a second element, component, region, layer or portion without departing from the teachings of the present disclosure.

Spatially relative terms such as "row", "column", "below", "above", "left", "right", etc. may be used herein for ease of description to describe factors such as the relationship of an element or feature to another element(s) or feature(s) illustrated in the figures. It will be understood that these spatially relative terms are intended to encompass different orientations of the device in use or operation in addition to the orientation depicted in the figures. For example, if the device in the figures is turned over, elements described as "below" other elements or features would then be oriented "above" other elements or features. Thus, the exemplary term "below" can encompass both an orientation of above and below. The device may be otherwise oriented (rotated 90 degrees or at other orientations) and the spatially relative descriptors used herein are interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to limit the present disclosure. As used herein, the singular forms "a," "an," and "the" are intended to comprise the plural forms as well, unless the context clearly dictates otherwise. It will be further understood that the terms "comprise" and/or "include" when used in this specification designate the presence of stated features, integers, steps, operations, elements and/or parts, but do not exclude the presence or addition of one or more other features, integers, steps, operations, elements, components and/or groups thereof. As used herein, the term "and/or" comprises any and all combinations of one or more of the associated listed items. In the description of this specification, description with reference to the terms "an embodiment," "another embodiment," etc. means that a particular feature, structure, material, or characteristic described in connection with the embodiment is included in at least one embodiment of the present disclosure. In this specification, schematic representations of the above terms are not necessarily directed to the same embodiment or example. Furthermore, the particular features, structures, materials or characteristics described may be combined in any suitable manner in any one or more embodiments or examples. Furthermore, those skilled in the art may combine the different embodiments or examples as well as the features of the different embodiments or examples described in this specification without conflicting each other.

It will be understood that when an element or layer is referred to as being "on", "connected to", "coupled to", or "adjacent to" another element or layer, it may be directly on, directly connected to, directly coupled to, or directly adjacent to another element or layer, or intervening elements or layers may be present. In contrast, when an element is referred to as being "directly on", "directly connected to", "directly coupled to", "directly adjacent to" another element or layer, with no intervening elements or layers present. However, in no case should "on" or "directly on" be interpreted as requiring a layer to completely cover the layer below.

Embodiments of the disclosure are described herein with reference to schematic illustrations (and intermediate structures) of idealized embodiments of the disclosure. As such, variations to the shapes of the illustrations are to be expected, e.g., as a result of manufacturing techniques and/or tolerances. Accordingly, embodiments of the present disclosure should not be construed as limited to the particular shapes of the regions illustrated herein, but are to comprise deviations in shapes due, for example, to manufacturing. Thus, the regions illustrated in the figures are schematic in nature and their shapes are not intended to illustrate the actual shape of a region of a device and are not intended to limit the scope of the present disclosure.

Unless otherwise defined, all terms (comprising technical and scientific terms) used herein have the same meaning as commonly understood by one of ordinary skill in the art to which this disclosure belongs. It will be further understood that terms such as those defined in commonly used dictionaries should be construed to have meanings consistent with their meanings in the relevant art and/or the context of this specification, and will not be idealized or overly interpreted in a formal sense, unless expressly defined as such herein.

As will be appreciated by those skilled in the art, although the steps of the methods of the present disclosure are depicted in a particular order in the figures, this does not require or imply that the steps must be performed in that particular order, unless the context clearly dictates otherwise. Additionally or alternatively, multiple steps may be combined into one step for execution, and/or one step may be decomposed into multiple steps for execution. Furthermore, other method steps may be inserted between the steps. The inserted steps may represent such as improvements of a method described herein, or may be unrelated to the method. Also, a given step may not be fully complete before the next step starts.

The above descriptions are merely specific embodiments of the present disclosure, but the protection scope of the present disclosure is not limited thereto. Any changes or substitutions that those skilled in the art can easily think of within the technical scope disclosed by the present disclosure, should be comprised within the protection scope of the present disclosure. Therefore, the protection scope of the present disclosure should be based on the protection scope of the claims.

## Claims

1. A light-emitting substrate comprising:
a base substrate comprising a plurality of light-emitting regions;
a plurality of light-emitting elements in each of the plurality of light-emitting regions;
a connection line in each light-emitting region and configured to connect the light-emitting elements in each light-emitting region; and
a first auxiliary plating in each light-emitting region and electrically insulated from the connection line and the light-emitting elements.

2. The light-emitting substrate according to claim 1, wherein each light-emitting region comprises a region occupied by the connection line and a blank region not occupied by the connection line, the first auxiliary plating is in the blank region, the first auxiliary plating comprises a main body extending along a first direction, the main body divides the blank region into a first portion and a second portion, and an area of the first portion is substantially equal to an area of the second portion.

3. The light-emitting substrate according to claim 2, wherein the first auxiliary plating further comprises a sub-part extending along a second direction and connected to the main body, the first direction intersects with the second direction.

4. The light-emitting substrate according to claim 3, wherein the main body of the first auxiliary plating comprises a first end and a second end opposite to each other in the first direction, the first end is closer to the connection line that is in a same light-emitting region as the first auxiliary plating compared to the second end, and the sub-part is connected to the second end of the main body.

5. The light-emitting substrate according to claim 2, wherein the first auxiliary plating has an open-loop structure.

6. The light-emitting substrate according to claim 5, wherein the first auxiliary plating further comprises a sub-part extending along a second direction and connected to the main body, the first direction intersects with the second direction, the main body is a rectangular ring comprising an opening to form the open-loop structure.

7. The light-emitting substrate according to claim 6,
wherein the main body of the first auxiliary plating comprises a first edge and a second edge opposite to each other in the first direction and a side edge connecting the first edge and the second edge, the opening is at the side edge, and the first edge is closer to the connection line that is in a same light-emitting region as the first auxiliary plating compared to the second edge, and
wherein the sub-part comprises a first sub-part and a second sub-part, the first sub-part is connected to the second edge and the side edge of the main body, the second sub-part is connected to the side edge of the main body and is closer to the second edge compared to the first edge, and the opening is between the first sub-part and the second sub-part.

8. The light-emitting substrate according to claim 5, wherein
the first auxiliary plating comprises three third sub-parts extending along the first direction and four fourth sub-parts extending along a second direction, the first direction intersects with the second direction, two of the four fourth sub-parts comprise an opening, the third sub-parts are connected to the fourth sub-parts to make an outline of the first auxiliary plating be the open-loop structure with an L shape, and
any two adjacent third sub-parts among the three third sub-parts have substantially equal spacing, and any two adjacent fourth sub-parts among the four fourth sub-parts have substantially equal spacing.

9. The light-emitting substrate according to any one of claims 1-8, further comprising:
a bonding region;
a plurality of bonding electrodes in the bonding region; and
a second auxiliary plating on both sides of the plurality of bonding electrodes in a second direction, the second auxiliary plating being electrically insulated from the plurality of bonding electrodes.

10. The light-emitting substrate according to claim 9, wherein the second auxiliary plating comprises a plurality of auxiliary electrodes, a width of each of the plurality of auxiliary electrodes along the second direction is equal to a width of each of the plurality of bonding electrodes along the second direction, and a spacing between any two adjacent auxiliary electrodes among the plurality of auxiliary electrodes is equal to a spacing between any two adjacent bonding electrodes among the plurality of bonding electrodes.

11. The light-emitting substrate according to claim 9, further comprising a third auxiliary plating on a side of the plurality of bonding electrodes away from the light-emitting regions and electrically insulated from the plurality of bonding electrodes, wherein the third auxiliary plating is in a strip shape, and a length of the third auxiliary plating along the second direction is greater than a length spanned by the plurality of bonding electrodes along the second direction.

12. The light-emitting substrate according to claim 11, wherein the third auxiliary plating is connected to the second auxiliary plating.

13. The light-emitting substrate according to claim 11, wherein the third auxiliary plating is not connected to the second auxiliary plating, and a distance between the third auxiliary plating and the second auxiliary plating is equal to a spacing between any two adjacent bonding electrodes among the plurality of bonding electrodes.

14. The light-emitting substrate according to any one of claims 1-8, further comprising:
an alignment mark; and
an annular auxiliary plating surrounding the alignment mark and electrically insulated from the alignment mark.

15. The light-emitting substrate according to claim 14, wherein one annular auxiliary plating surrounds one alignment mark.

16. The light-emitting substrate according to claim 14, wherein one annular auxiliary plating surrounds a plurality of alignment marks.

17. The light-emitting substrate according to any one of claims 9-13, further comprising a plurality of driving voltage signal lines extending along a first direction, wherein,
the plurality of light-emitting regions are arranged in multiple rows and multiple columns, each column of light-emitting regions comprises a driving voltage signal line, and a plurality of connection lines in a same column are connected to a same driving voltage signal line,
the connection line in each light-emitting region and the driving voltage signal line connected to the connection line respectively have a first spacing from the first auxiliary plating in the light-emitting region,
the first auxiliary plating is in a same layer as the connection line and the driving voltage signal line, and
the second auxiliary plating is in a same layer as the bonding electrodes, the connection line and the driving voltage signal line.

18. The light-emitting substrate according to claim 17, wherein each light-emitting region comprises a region occupied by the connection line and a blank region not occupied by the connection line, the first auxiliary plating is in the blank region and has an open-loop structure, and a width of the first auxiliary plating is greater than or equal to a width of the driving voltage signal line.

19. The light-emitting substrate according to claim 17, further comprising:
a plurality of driving circuits, wherein each light-emitting region comprises a driving circuit connected to the light-emitting elements in the light-emitting region, and the driving circuits in each column of light-emitting regions are cascaded in sequence; and
a plurality of common voltage signal lines extending along the first direction, wherein each column of light-emitting regions comprises a common voltage signal line connected to a ground terminal of each driving circuit in a column of light-emitting regions.

20. The light-emitting substrate according to claim 19, further comprising:
a plurality of power signal lines extending along the first direction, wherein each column of light-emitting regions comprises a power signal line connected to a power terminal of each driving circuit in the column of light-emitting regions;
a plurality of address selection signal lines extending along the first direction, wherein each column of light-emitting regions comprises an address selection signal line connected to an address terminal of a first cascaded driving circuit in the column of light-emitting regions; and
a plurality of feedback signal lines extending along the first direction, wherein each column of light-emitting regions comprises a feedback signal line connected to an output terminal of a last cascaded driving circuit in the column of light-emitting regions.

21. The light-emitting substrate according to claim 20, wherein a spacing between the driving voltage signal line in each column of light-emitting regions and the feedback signal line in another column of light-emitting regions adjacent to the column of light-emitting regions is equal to the first spacing.

22. The light-emitting substrate according to claim 21, wherein the first spacing is approximately 200 µm.

23. The light-emitting substrate according to claim 20, wherein the plurality of light-emitting elements are arranged in multiple rows and multiple columns, the driving voltage signal line, the common voltage signal line and the feedback signal line extend beyond the first row of light-emitting elements or at least flush with the first row of light-emitting elements in the first direction.

24. A backlight comprising the light-emitting substrate according to any one of claims 1-23.

25. A display device comprising the light-emitting substrate according to any one of claims 1-23.

26. A method of preparing a light-emitting substrate, comprising:
providing a base substrate that comprises a plurality of light-emitting regions;
forming a connection line and a first auxiliary plating in each of the light-emitting regions of the base substrate; and
mounting a light-emitting element on a side of the connection line and the first auxiliary plating in each light-emitting region away from the base substrate,
wherein the connection line is configured to connect the light-emitting elements in each light-emitting region, and the first auxiliary plating is electrically insulated from the connection line and the light-emitting elements.

27. The method according to claim 26, wherein the light-emitting substrate further comprises a bonding region, the forming the connection line and the first auxiliary plating in each of the light-emitting regions of the base substrate, further comprises:
applying a conductive layer on the base substrate and patterning the conductive layer to simultaneously form signal lines, the connection line and the first auxiliary plating in the light-emitting region, a plurality of bonding electrodes in the bonding region, a second auxiliary plating and a third auxiliary plating,
wherein,
the signal lines extend along a first direction, the signal lines comprise a driving voltage signal line, a common voltage signal line, a power signal line, an address selection signal line, and a feedback signal line, the plurality of light-emitting regions are arranged in multiple rows and multiple columns, and each column of light-emitting regions comprises the driving voltage signal line, the common voltage signal line, the power signal line, the address selection signal line, and the feedback signal line,
the second auxiliary plating is on both sides of the plurality of bonding electrodes in a second direction and is electrically insulated from the plurality of bonding electrodes, the second direction intersects with the first direction, and
the third auxiliary plating is on a side of the plurality of bonding electrodes away from the light-emitting regions and is electrically insulated from the plurality of bonding electrodes, the third auxiliary plating is in a strip shape, and a length of the third auxiliary plating along the second direction is greater than a length spanned by the plurality of bonding electrodes along the second direction.

28. The method according to claim 27, wherein the applying the conductive layer on the base substrate and patterning the conductive layer, comprises:
forming a first conductive layer on the base substrate;
forming a patterned photoresist on a side of the first conductive layer away from the base substrate;
forming a second conductive layer on a surface of the first conductive layer that is not shielded by the photoresist through an electroplating addition method, a thickness of the second conductive layer being greater than a thickness of the first conductive layer;
stripping the photoresist; and
etching the first conductive layer that is exposed.

29. The method according to claim 28, wherein a ratio of an area of the second conductive layer to an area of the base substrate is approximately 30%~40%.

30. The method according to any one of claims 26-29, wherein the base substrate comprises four process edges, the method further comprises:
forming a fourth auxiliary plating with a strip shape on the four process edges of the base substrate, orthographic projections of the four process edges on the base substrate respectively fall within orthographic projections of four fourth auxiliary platings on the base substrate; and
cutting off the four process edges.
